# EUROPEAN PATENT APPLICATION

(11) **EP 1 791 403 A2**
(43) Date of publication of application: **30.05.2007**
(21) Application number: 06024401.9
(22) Date of filing: 24.11.2006
(51) Int. Cl.: H05K 1/02

(54) **Printed wiring board**

(30) Priority: 25.11.2005 JP 2005339808
(71) Applicant: Funai Electric Co., Ltd., Daito-shi, Osaka 574-0013 (JP)
(72) Inventor: Kobayashi, Hiroyuki, Daito-shi, Osaka 574-0013 (JP)
(74) Representative: Grünecker, Kinkeldey, Stockmair & Schwanhäusser Anwaltssozietät

(57) **Abstract**

A printed wiring board (100) including: a first VIA (7) for allowing a second wiring (6) to penetrate the printed wiring board from a front surface to a rear surface of the board; a second VIA (8) for allowing the second wiring (6) to penetrate the board from the rear surface to the front surface; an alignment interval (9) where the first and second wirings (5, 6) are arranged on the front and rear surfaces of the board, respectively, and the first and second wiring are substantially parallel to each other in plan view; a first interval (10) provided between the first VIA (7) and the alignment interval (9); and a second interval (11) provided between the alignment interval (9) and the second VIA (8), in each of first and second intervals, the first wiring (5) is formed crookedly such that the first wiring (5) and the second wiring (6) have substantially the same length.

## Description

### BACKGROUND OF THE INVENTION

### Field of the Invention

The present invention relates to a printed wiring board.

### Description of Related Art

A printed wiring board on which wirings for transmitting radio-frequency signals are formed with curvature to secure an equivalent length (isometry) of the wirings and thereby to reduce a variation in transmission time of the radio-frequency signal, is known (for example, JP-Hei-11-008444A).

Further, another printed wiring board on both surfaces of which wirings are provided and in which a closed circuit is formed between a plurality of wirings (JP 2005-109022 A), is also known. In the printed wiring board, one wiring is guided from one surface to the other surface of the printed wiring board through a VIA, whereby the wiring intersects with the other wiring with the printed wiring board sandwiched between them, and further two wirings are twisted to each other on both surfaces of the printed wiring board so as to be symmetrical on a plan view, whereby magnetic fields produced by loop currents flowing through the closed circuits are cancelled to each other.

Further, a still another printed wiring board with two ICs (Integrated Circuits) provided thereon is known, on which ICs are connected with each other through a single wiring for transmitting a signal. The single wiring is separated into two wiring portions, and one of the separated wirings is formed on a front surface of the printed wiring board and connected to one of ICs, and the other of the separated wirings is guided from the front surface to the rear surface of the printed wiring board through a VIA and is formed on the rear surface, and the other wiring is further guided from the rear surface to the front surface again through another VIA to be connected to the other of ICs (JP 2004-119454A).

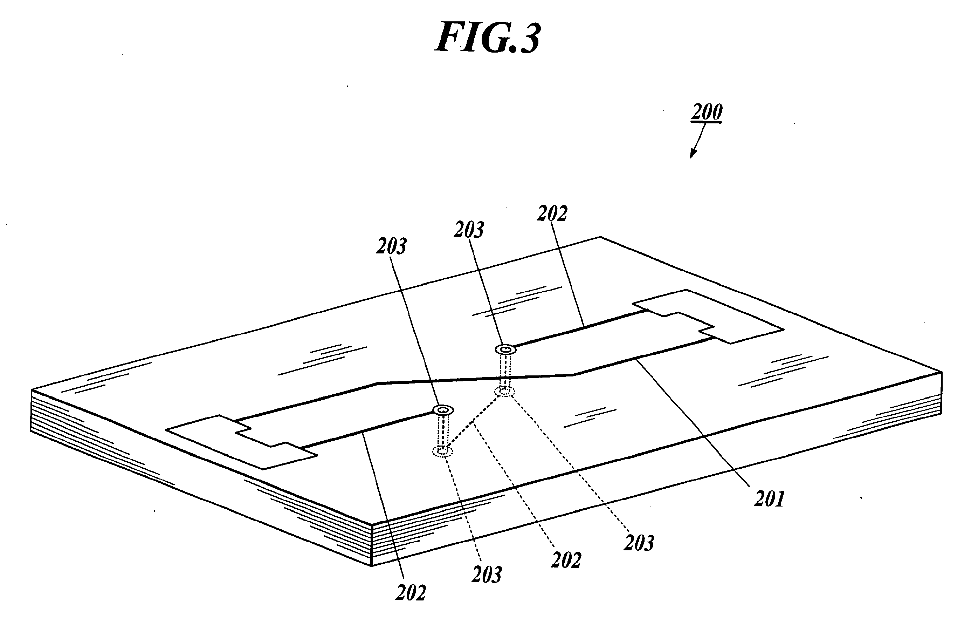

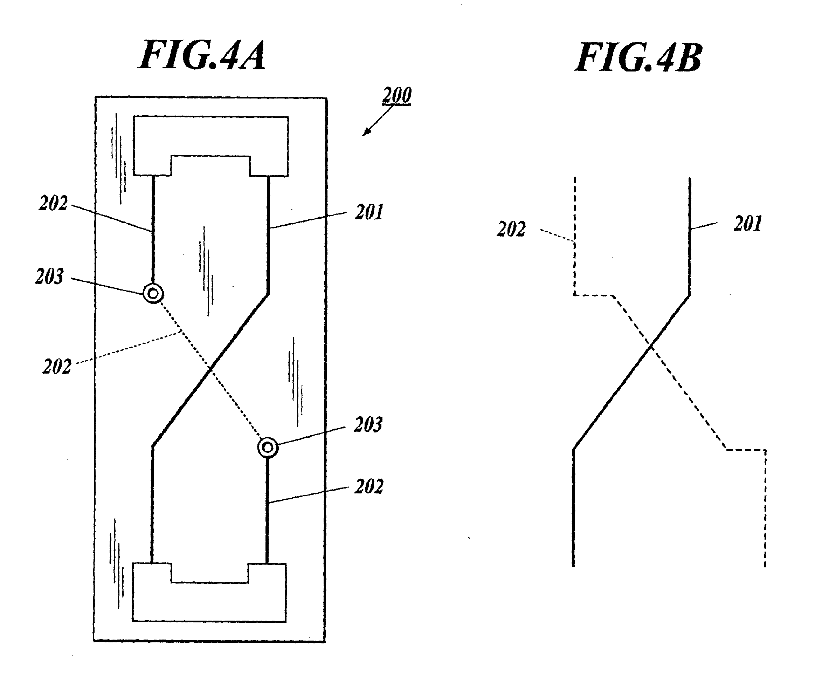

Meanwhile, for transmission of a radio-frequency signal, a differential transmission technology is frequently used because the differential transmission technology is hardly disturbed by effects of external noises. In the differential transmission technology, differential signals (P-signal and N-signal) are transmitted through two wirings which are disposed in parallel with each other, whereby a radio-frequency signal is transmitted. On the printed wiring board, an alignment of output terminals for outputting P-signal and N-signal in the output side is sometimes opposite to the alignment of input terminals for receiving P-signal and N-signal in the input side. In this case, for example, as shown in FIG. 3 and FIG. 4A, one wiring 202 of two wirings 201, 202 for differential transmission is guided from the front surface to the rear surface of the printed wiring board 200 through a VIA 203 and guided again from the rear surface to the front surface through another VIA 203, whereby two wirings 201, 202 are allowed to intersect with each other.

As described above, in a case that the wirings 201, 202 for differential transmission intersect with each other, the wiring 202 formed on the rear surface is longer than the wiring 201 formed on the front surface by an amount equivalent to two times of the thickness of the printed wiring board 200, as shown in FIG. 4B. Therefore, two wirings 201, 202 for differential transmission are different in length and as a result, there arises a problem that the differential signals need different transmission time to travel along the wirings 201, 202. Further, the intersection of the two wirings 201, 202 may cause disturbance in characteristic impedance matching of the wirings 201, 202, whereby reflection to the transmission of radio-frequency signal is caused. The reflection of the radio-frequency signal can be a cause for various errors in signal transmission.

In the technique disclosed by JP-Hei-11-008444A, since one of two wirings is guided from the front surface to the rear surface of the printed wiring board through the VIA, the wirings are different in length. Therefore, the technique cannot solve the above problems. Further, the wirings which are formed with curvature on the printed wiring board can disturb the characteristic impedance of the wirings. In the technique disclosed in JP-2005-109022A, since the wirings intersect with each other, the characteristic impedance of the wirings is disturbed. In the technique disclosed by JP-2004-119454A, it is not taken into consideration that it is hard to keep two wirings equivalent in length, since one of them is guided to penetrate the printed wiring board through the VIA.

### SUMMARY OF THE INVENTION

The present invention has been made to solve the problems involved in the conventional printed wiring boards, and has an object to provide a printed wiring board, wirings formed on which keep an equivalent length even though they intersect with each other, and whereby disturbance in the characteristic impedance of the wirings is reduced.

In accordance of the first aspect of the invention, the printed wiring board includes: an output unit for outputting a differential signal, the differential signal including a first signal and a second signal; an input unit for receiving the differential signal output from the output unit; a first wiring for transmitting the first signal of the differential signal from the output unit to the input unit; a second wiring for transmitting the second signal of the differential signal from the output unit to the input unit, the second wiring intersecting with the first wiring,
wherein the printed wiring board further includes:
a first VIA for allowing the second wiring to penetrate the printed wiring board from a front surface of the board to a rear surface of the board;
a second VIA for allowing the second wiring to penetrate the printed wiring board from the rear surface to the front surface;
an alignment interval where the first wiring and the second wiring are arranged on the front surface and the rear surface, of the printed wiring board, respectively, and the first wiring and the second wiring form a substantially single line in plan view;
a first interval provided between the first VIA and the alignment interval, in which the first wiring is formed crookedly such that the first wiring and the second wiring have substantially the same length; and
a second interval provided between the alignment interval and the second VIA, in which the first wiring is formed crookedly such that the first wiring and the second wiring have substantially the same length, and
the alignment interval has a length equal to or more than 10 mm.

According to the first aspect of the present invention, in an alignment interval, a first wiring to be formed on a front surface of a printed wiring board and a second wiring penetrating the printed wiring board from the front surface to the rear surface through a first VIA to be formed on the rear surface of the printed wiring board are arranged as if both wirings form a single line when the printed wiring board is viewed vertically. Therefore, this arrangement of the wirings resolves disturbance in the characteristic impedance of the wirings which is caused by intersection of the first and second wiring in a first interval. As a result, the disturbance in the characteristic impedance of the wirings caused by an intersection of the first wiring and second wiring is reduced throughout the whole interval.

Further, in the first interval and second interval, the first wiring is formed crookedly such that the first wining and second wiring have the same length. Therefore, the first wining and second wiring have the same length in total.

As described above, in the alignment interval, the first wiring to be formed on the front surface of the printed wiring board and the second wiring to be formed on the rear surface of the printed wiring board are arranged as if both wirings form a single line when the printed wiring board is viewed vertically. Therefore, a more space is saved on the printed wiring board, in comparison with the case where the first wiring and second wiring arranged as if the wirings are formed separately when the printed wiring board is viewed vertically.

Further, the alignment interval is equal to or more than 10 mm long. For example, in the case where a radio-frequency signal of 1 to 10 GHz is transmitted, disturbance in the characteristic impedance of the wirings is reduced to such extent no disturbance is caused in radio-frequency signal transmission.

In accordance of the second aspect of the invention, the printed wiring board includes: an output unit for outputting a differential signal, the differential signal including a first signal and a second signal; an input unit for receiving the differential signal output from the output unit; a first wiring for transmitting the first signal of the differential signal from the output unit to the input unit; a second wiring for transmitting the second signal of the differential signal from the output unit to the input unit, the second wiring intersecting with the first wiring,
wherein the printed wiring board further includes: a first VIA for allowing the second wiring to penetrate the printed wiring board from a front surface of the board to a rear surface of the board;
a second VIA for allowing the second wiring to penetrate the printed wiring board from the rear surface to the front surface;
an alignment interval where the first wiring and the second wiring are arranged on the front surface and the rear surface, of the printed wiring board, respectively, and the first wiring and the second wiring are substantially parallel to each other in plan view;
a first interval provided between the first VIA and the alignment interval, in which the first wiring is formed crookedly such that the first wiring and the second wiring have substantially the same length; and
a second interval provided between the alignment interval and the second VIA, in which the first wiring is formed crookedly such that the first wiring and the second wiring have substantially the same length.

According to the second aspect of the present invention, in the alignment interval, the first wiring to be formed on the front surface of the printed wiring board and the second wiring penetrating the printed wiring board from the front surface to the rear surface through a first VIA to be formed on the rear surface of the printed wiring board are arranged in parallel with each other. Therefore, the arrangement of the wirings resolves disturbance in the characteristic impedance of the wirings which is caused by an intersection of the first and second wiring in the first interval. As a result, the disturbance in the characteristic impedance of the wirings, caused by the intersection of the first and second wiring is reduced throughout the whole interval.

Further, in the first interval and second interval, the first wiring is formed crookedly such that the first wining and second wiring have the same length. Therefore, the first wiring and second wiring have the same length in total.

In the second aspect of the invention, preferably, in the alignment interval, the first wiring and the second wiring are arranged on the front surface and the rear surface, of the printed wiring board, respectively, and the first wiring and the second wiring form a substantially single line in plan view.

The advantages similar to those obtained by the second aspect of the invention is also obtained in the printed wiring board having the structure described below. Particularly in the alignment interval, the first wiring to be formed on the front surface of the printed wiring board and the second wiring to be formed on the rear surface of the board are arranged as if both wirings form a single line when the printed wiring board is viewed vertically. Therefore, a more space can be saved on the printed wiring board, compared with the case where the first wiring and second wiring arranged as if the wirings are formed separately when the printed wiring board is viewed vertically.

### BRIEF DESCRIPTION OF THE DRAWINGS

The present invention will be more fully understood from the detailed description given herein after and the accompanying drawings given by way of illustration only, and thus are not intended as a definition of limits of the present invention, and wherein:
FIG. 1 is a perspective view illustrating a printed wiring board according to the present invention;
FIG. 2 is a plan view illustrating the printed wiring board according to the present invention;
FIG. 3 is a perspective view illustrating a conventional printed wiring board;
FIG. 4A is a plan view illustrating the conventional printed wiring board, and FIG. 4B is a view for illustrating lengths of wirings on the printed wiring board.

### PREFERRED EMBODIMENTS OF THE INVENTION

Now, an embodiment of a printed wiring board according to the present invention will be described in detail with reference to the accompanying drawings.

A printed wiring board 100 according to the embodiment of the invention is made of a board impregnated with an insulating resin or the like, such as a paper-phenol board, paper-epoxy board, glass-epoxy board, Teflon (trade mark) board or the like. Wirings are formed on a front surface 1 and a rear surface 2 of the printed wiring board 100.

The printed wiring board 100 has, for example, a thickness of approximately 16 mm.

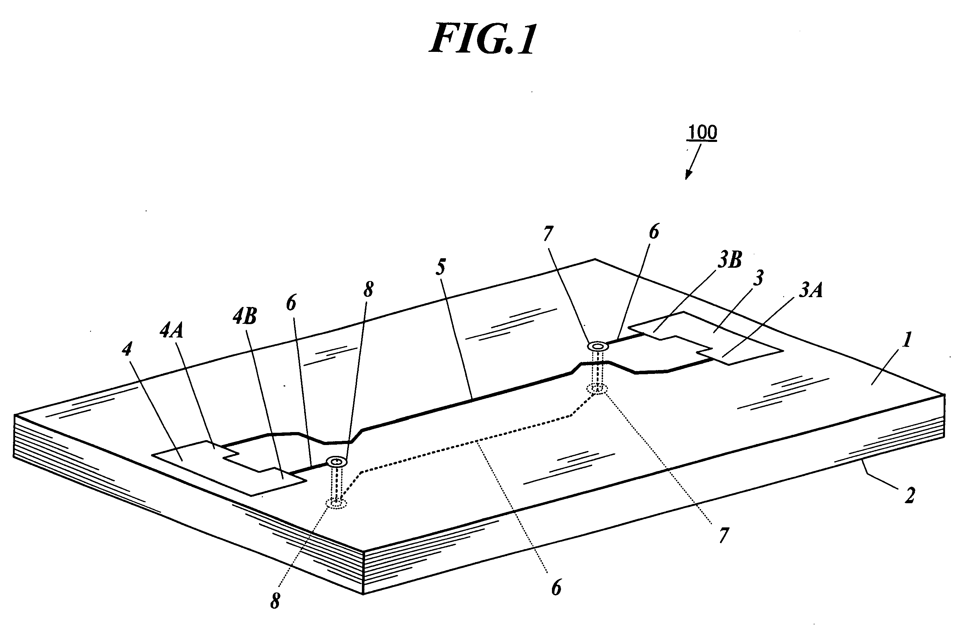

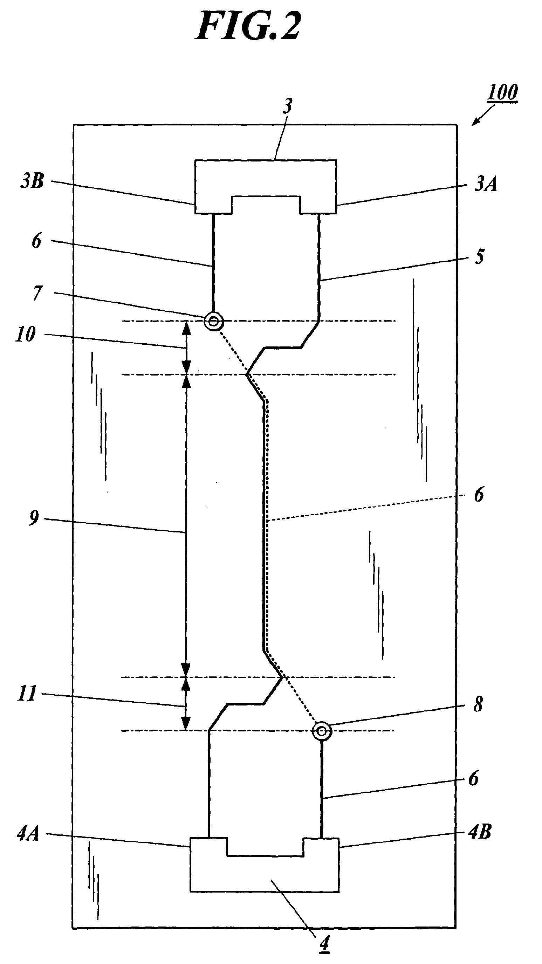

On the front surface 1 of the printed wiring board 100, an output unit 3 for outputting a differential signal and an input unit 4 for receiving the differential signal, are provided, as shown in FIG. 1 and FIG. 2.

The differential signal comprises P-signal and N-signal (reversed P-signal) and is used for transmission of radio-frequency signals. For instance, the radio-frequency signal is a signal having a frequency falling within a frequency range from approximately 1 to 10 GHz.

The output unit 3 is provided with an output terminal 3A for outputting P-signal (first signal) of the differential signal, and an output terminal 3B for outputting N-signal (second signal) of the differential signal. Meanwhile, the input unit 4 is provided with an input terminal 4A for receiving P-signal and an input terminal 4B for receiving N-signal.

As shown in FIG. 1 and FIG. 2, on the printed wiring board 100, a first wiring 5 for transmitting P-signal from the output unit 3 to the input unit 4, and a second wiring 6 for transmitting N-signal from the output unit 3 to the input unit 4, are formed.

An alignment of the output terminal 3A for outputting P-signal and the output terminal 3B for outputting N-signal is opposite to the alignment of the input terminal 4A for receiving P-signal and the input terminal 4B for receiving N-signal. The printed wiring board 100 is provided with a first VIA 7 which allows the second wiring 6 to penetrate the printed wiring board 100 from the front surface 1 to the rear surface 2 and a second VIA 8 which allows the second wiring 6 to penetrate the printed wiring board 100 from the rear surface 2 to the front surface 1. The second wiring 6 is allowed to penetrate the printed wiring board 100 from the front surface 1 to the rear surface 2 through the first VIA 7 and further to penetrate the printed wiring board 100 from the rear surface 2 to the front surface 1 through the second VIA 8, whereby the second wiring 6 is allowed to intersect with the first wiring 5 in a plan view.

More specifically, the first wiring 5 and second wiring 6 are arranged to run in parallel with each other on the printed wiring board 100 so as to form a coplanar line extending from a pair of output terminals 3A, 3B in the direction of signal transmission. Thereafter, the second wiring 6 is guided to penetrate the printed wiring board 100 from the front surface 1 to the rear surface 2 through the first VIA 7. Then, the first wiring 5 and second wiring 6 are arranged respectively on the front surface 1 and rear surface 2 of the wiring board 100, as if both wirings 5 and 6 form a single line in plan view, to form a coplanar line vertically in the printed wiring board 100. Thereafter, the second wiring 6 is further guided to penetrate the printed wiring board 100 from the rear surface 2 to the front surface 1 through the second VIA 8. Then, both first wiring 5 and second wiring 6 are guided in parallel with each other on the front surface 1 of the printed wiring board 100 to form a coplanar line extending toward a pair of input terminals 4A, 4B in the direction of signal transmission.

Hereinafter, an interval where the first wiring 5 and the second wiring 6 are arranged respectively on the front surface 1 and rear surface 2 of the printed wiring board 100, as if both wirings 5, 6 form a single line in plan view, is referred to as an alignment interval 9. Further, an interval from the first VIA 7 to the alignment interval 9 is referred to as a first interval 10, and an interval from the alignment interval 9 to the second VIA 8 is referred to as a second interval 11. Note that it is good enough for the first wiring 5 and second wiring 6 that both wirings are formed in parallel with each other in the alignment interval 9, and there is no need for these wirings to be arranged to form a single line in plan view. The alignment interval is preferably, for example, equal to or more than 10 mm in length.

As shown in FIG. 2, the first wiring 5 is formed crookedly in the first interval 10 so as to ensure that the first wiring 5 has the same length as the second wiring 6 in the first interval 10.

Meanwhile, also in the second interval 11, the first wiring 5 is formed crookedly so as to ensure that the first wiring 5 has the same length as the second wiring 6 in the first interval 11 in the same fashion as in the first interval 10.

In the above described printed wiring board 100 of the present invention, the first wiring 5 to be formed on the front surface 1 of the printed wiring board 100 and the second wiring 6 penetrating the printed wiring board 100 from the front surface 1 to the rear surface 2 to be formed thereon are arranged in the alignment interval 9 as if both wirings 5, 6 form a single line when the printed wiring board 100 is viewed vertically. Therefore, this arrangement of the wirings can solve a problem that characteristic impedance of the wirings formed on the printed wiring board 100 is disturbed by an intersection of the first wiring 5 and second wiring 6 in the first interval 10. As the result, disturbance in the characteristic impedance due to the intersection of the first wiring 5 and second wiring 6 can be reduced to an acceptable extent.

Further, since the first wiring 5 is formed crookedly so as to ensure that the first wiring 5 has the same length as the second wiring 6 in the first interval 10 and the second interval 11, the first and second wiring 5, 6 have the same length in total.

As described above, the first wiring 5 and second wiring 6 to be formed respectively on the front surface 1 and rear surface 2 of the printed wiring board 100 are arranged in the alignment interval 9, as if both wirings 5, 6 form a single line when the printed wiring board 100 is viewed vertically. Therefore, a space can be saved on the printed wiring board 100.

Since the first wiring 5 and second wiring 6 are formed so as to provide a coplanar line, equipotential surface produced in the vicinity of the first wiring for transmitting P-signal and equipotential surface produced in the vicinity of the second wiring for transmitting N-signal work together to negate their effects, whereby a virtual ground level is formed between the first wiring 5 and the second wiring 6. As the result, radio-frequency signal transmission is hardly receives external noise effects.

Note, the crooked pattern of the first wiring 5 is not limited to those described or displayed in the embodiment, but the wiring may be crooked in any way as far as both first and second wiring 5, 6 are allowed to keep the same length.

## Claims

1. A printed wiring board comprising: an output unit for outputting a differential signal, the differential signal including a first signal and a second signal; an input unit for receiving the differential signal output from the output unit; a first wiring for transmitting the first signal of the differential signal from the output unit to the input unit; a second wiring for transmitting the second signal of the differential signal from the output unit to the input unit, the second wiring intersecting with the first wiring,
wherein the printed wiring board further comprises:
a first VIA for allowing the second wiring to penetrate the printed wiring board from a front surface of the board to a rear surface of the board;
a second VIA for allowing the second wiring to penetrate the printed wiring board from the rear surface to the front surface;
an alignment interval where the first wiring and the second wiring are arranged on the front surface and the rear surface, of the printed wiring board, respectively, and the first wiring and the second wiring form a substantially single line in plan view;
a first interval provided between the first VIA and the alignment interval, in which the first wiring is formed crookedly such that the first wiring and the second wiring have substantially the same length; and
a second interval provided between the alignment interval and the second VIA, in which the first wiring is formed crookedly such that the first wiring and the second wiring have substantially the same length, and
the alignment interval has a length equal to or more than 10 mm.

2. A printed wiring board comprising: an output unit for outputting a differential signal, the differential signal including a first signal and a second signal; an input unit for receiving the differential signal output from the output unit; a first wiring for transmitting the first signal of the differential signal from the output unit to the input unit; a second wiring for transmitting the second signal of the differential signal from the output unit to the input unit, the second wiring intersecting with the first wiring,
wherein the printed wiring board further comprises: a first VIA for allowing the second wiring to penetrate the printed wiring board from a front surface of the board to a rear surface of the board;
a second VIA for allowing the second wiring to penetrate the printed wiring board from the rear surface to the front surface;
an alignment interval where the first wiring and the second wiring are arranged on the front surface and the rear surface, of the printed wiring board, respectively, and the first wiring and the second wiring are substantially parallel to each other in plan view;
a first interval provided between the first VIA and the alignment interval, in which the first wiring is formed crookedly such that the first wiring and the second wiring have substantially the same length; and
a second interval provided between the alignment interval and the second VIA, in which the first wiring is formed crookedly such that the first wiring and the second wiring have substantially the same length.

3. The printed wiring board as claimed in claim 2, wherein, in the alignment interval, the first wiring and the second wiring are arranged on the front surface and the rear surface, of the printed wiring board, respectively, and the first wiring and the second wiring form a substantially single line in plan view.
